# EUROPEAN PATENT SPECIFICATION

(11) **EP 3 430 469 B1**
(45) Date of publication and mention of the grant of the patent: **16.12.2020**
(21) Application number: 16838057.4
(22) Date of filing: 23.08.2016
(51) Int. Cl.: G02F 1/1345, G02F 1/1333, H05K 1/03

(54) **FLEXIBLE CIRCUIT BOARD, ARRAY SUBSTRATE, FABRICATING METHOD THEREOF, AND DISPLAY APPARATUS**
FLEXIBLE LEITERPLATTE, ARRAYSUBSTRAT, HERSTELLUNGSVERFAHREN DAFÜR UND ANZEIGEVORRICHTUNG
CARTE DE CIRCUIT FLEXIBLE, SUBSTRAT DE MATRICE, PROCÉDÉ DE FABRICATION ASSOCIÉ ET APPAREIL D'AFFICHAGE

(30) Priority: 18.03.2016 CN 201610159276
(43) Date of publication of application: 23.01.2019
(73) Proprietor: BOE Technology Group Co., Ltd., Beijing 100015 (CN)
(72) Inventor: LU, Jiaoming, Beijing 100176 (CN); ZHAO, Weili, Beijing 100176 (CN)
(74) Representative: Cohausz & Florack
(86) International application number: PCT/CN2016/096378
(87) International publication number: WO 2017/156981

(56) References cited:
- WO-A1-2015/053309
- WO-A1-2015/053309
- CN-A- 101 027 753
- CN-A- 104 519 666
- CN-A- 104 553 224
- CN-A- 105 144 418
- CN-A- 105 383 120
- CN-A- 105 572 947
- JP-A- H02 235 387
- US-A- 5 473 118
- US-A1- 2005 237 467
- US-A1- 2005 237 467
- US-A1- 2011 217 892

## Description

### CROSS-REFERENCES TO RELATED APPLICATIONS

This PCT patent application claims priority of Chinese Patent Application No. 201610159276.3 filed on March 18, 2016.

### TECHNICAL FIELD

The disclosed subject matter generally relates to display technologies and, more particularly, relates to a flexible circuit board, an array substrate, a fabricating method thereof, and a related display apparatus.

### BACKGROUND

The existing curved advanced super dimension switch type liquid crystal display (ADS-LCD) suffers a light leakage problem at the edges in a dark state.

Accordingly, it is desirable to provide a flexible circuit board, an array substrate, a fabricating method thereof, and a related display apparatus to at least partially alleviate one or more problems set forth above and to solve other problems in the art.

### BRIEF SUMMARY

In accordance with the invention, an array substrate according to claim 1, a fabrication method of an array substrate according to claim 7 and a display device according to claim 13 are provided.

An aspect of the present disclosure provides a flexible circuit board, comprising: a base substrate made of a soft cloth material; and a flexible driving circuit structure formed on the base substrate.

In some examples, the base substrate withstands a temperature during a process for forming the flexible driving circuit structure on the base substrate, and a temperature during a process for bonding the flexible circuit board to a main substrate.

In some examples, the soft cloth material includes polytetrafluoroethylene.

In some examples, the flexible driving circuit structure comprises:
a patterned flexible conductive layer including a plurality of conducting wires;
a patterned flexible insulating layer formed on the patterned flexible conductive layer; and at least one circuit chip plugged in the patterned flexible insulating layer and contacted with the patterned flexible conductive layer.

In some examples, the patterned flexible conductive layer is made of a conductive ink being printed on the base substrate.

Another aspect of the disclosure provides an array substrate, comprising: a main substrate including a central display region and a peripheral wiring region, wherein a plurality of conducting wire terminals are disposed in the peripheral wiring region; and at least one disclosed flexible circuit board bonded on the peripheral wiring region of the main substrate; wherein the flexible driving circuit structure of each flexible circuit board further includes a plurality of connecting terminals that are correspondently electrically connected with at least a part of the plurality of conducting wire terminals of the main substrate.

In some examples, a withstand temperature of the base substrate is no lower than 200°C.

In some examples, the base substrate is a polytetrafluoroethylene high temperature cloth.

In some examples, the plurality of connecting terminals of the flexible driving circuit structure is formed from the plurality of conducting wires in the patterned flexible conductive layer.

In some examples, the array substrate further comprises: a thin film transistor in the central display region of the main substrate; wherein a plurality of connecting terminals of the thin film transistor are connected to at least a part of the plurality of conductive wiring terminals through a part of the plurality of conducting wires that extend to the peripheral wiring region.

Another aspect of the disclosure provides a method for fabricating a flexible circuit board, comprising: using a soft cloth material to form a base substrate; and forming a flexible driving circuit structure on the base substrate.

Another aspect of the disclosure provides a method for fabricating an array substrate, comprising: forming a main substrate including a central display region and a peripheral wiring region, wherein a plurality of conducting wire terminals are disposed in the peripheral wiring region; forming at least one flexible circuit board using the disclosed method; and bonding the at least one flexible circuit board on the peripheral wiring region.

In some examples, the at least one flexible circuit board is bounded on the peripheral wiring region of the main substrate by a hot pressing process.

In some examples, the base substrate is formed of a polytetrafluoroethylene high temperature cloth.

In some examples, forming each flexible circuit board comprises: forming a metal film on a flat surface of the base substrate by sputtering nickel alloy and copper; thickening the metal film by plating copper to form a non-patterned flexible conductive layer; and using a punching process to form at least one sprocket hole in the non-patterned flexible conductive layer .

In some examples, forming each flexible circuit board further comprises: forming a photoresist pattern film on a surface of the non-patterned flexible conductive layer; and spraying an etchant liquid to etch the non-patterned flexible conductive layer that is not covered by the photoresist pattern film to form a patterned flexible conductive layer including a plurality of connecting wires.

In some examples, forming each flexible circuit board comprises: printing a conductive ink on the base substrate to form a patterned flexible conductive layer.

In some examples, forming each flexible circuit board further comprising: after releasing the photoresist pattern film, performing a tinning process on the patterned flexible conductive layer; and printing an insulating resist film to form a patterned insulating layer on the patterned flexible conductive layer.

In some examples, forming each flexible circuit board further comprising: plugging at least one circuit chip into the patterned insulating layer by using a reflow process and a cartridge process to make the at least one circuit chip contact with the patterned flexible conductive layer; and performing an external packaging process.

Another aspect of the present disclosure provides an display apparatus comprising the disclosed array substrate.

Other aspects of the present disclosure can be understood by those skilled in the art in light of the description, the claims, and the drawings of the present disclosure.

### BRIEF DESCRIPTION OF THE DRAWINGS

Various objects, features, and advantages of the disclosed subject matter can be more fully appreciated with reference to the following detailed description of the disclosed subject matter when considered in connection with the following drawings, in which like reference numerals identify like elements. It should be noted that the following drawings are merely examples for illustrative purposes according to various disclosed embodiments and are not intended to limit the scope of the present disclosure.
FIG. 1 is schematic diagram of an existing curved ADS-LCD that suffers a light leakage problem in a dark state;
FIG. 2 is a schematic diagram of a complete structure of an exemplary array substrate in accordance with some embodiments of the disclosed subject matter;
FIG. 3 is a schematic diagram of conductive wiring terminals in a peripheral wiring region on a main substrate in accordance with some embodiments of the disclosed subject matter;
FIG. 4 is a schematic diagram of connecting terminals of a flexible driving circuit structure on a flexible circuit board in accordance with some embodiments of the disclosed subject matter; and
FIG. 5 is a schematic cross-sectional structural diagram of a flexible circuit board in accordance with some embodiments of the disclosed subject matter.

### DETAILED DESCRIPTION

For those skilled in the art to better understand the technical solution of the disclosed subject matter, reference will now be made in detail to exemplary embodiments of the disclosed subject matter, which are illustrated in the accompanying drawings. Wherever possible, the same reference numbers will be used throughout the drawings to refer to the same or like parts. Embodiments of the invention necessarily comprise all the features of independent claim 1 or of independent claim 7. In the following description, "embodiments" or "embodiments of the disclosure" represent embodiments of the invention only if they comprise all the features of claim 1 or of claim 7.

In accordance with various embodiments, the disclosed subject matter provides an array substrate, a fabricating method thereof, and a related display apparatus.

The existing curved ADS-LCD may suffer a light leakage problem under a dark state. A pad area of the existing curved ADS-LCD often includes multiple metal wires. Thus a bonding flexible printed circuit (FPC) board of the existing curved ADS-LCD often suffers from stress cause by the packaging structure of the pad area.

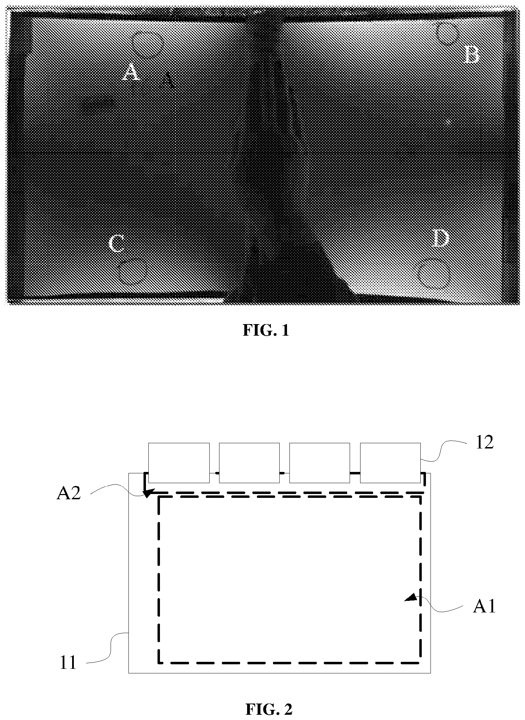

As illustrated in FIG. 1, for example, in an existing curved ADS-LCD, the brightness level of light leakage at the four positions marked out by circles are respectively 4.6 nit at A, 5.0 nit at B, 3.3 nit at C, and 3.7 nit at D. As shown in FIG. 1, in the curved ADS-LCD, the light leakage often occurs in the vicinity of the four corners of the display panel of the ADS-LCD.

In some embodiments of the present disclosure, a soft cloth, such as a polytetrafluoroethylene (Teflon) high temperature cloth, is used as a base substrate of the FPC. Multiple electrodes on the cloth can be printed by using a conductive ink. Therefore, the stress applied on the bonding FPC can be reduced, and the light leakage problem can be alleviated.

In some embodiments of the present disclosure, other materials softer and/or thinner than a polytetrafluoroethylene (Teflon) high temperature cloth can be used as a base substrates of the FPC. The electrodes can be printed on the base substrate by a conductive ink. The stress applied on the bonding FPC can therefore be reduced, and the light leakage problem can be alleviated.

Referring to FIG. 2, a schematic diagram of an exemplary array substrate is shown in accordance with some embodiments of the disclosed subject matter.

As illustrated, the array substrate comprises a main substrate 11, and at least one flexible circuit board 12 bonded to an edge of the main substrate 11. For example, four flexible circuit boards 12 are shown in FIG. 2.

The main substrate 11 includes a central display region A1, and a peripheral wiring region A2. Multiple conductive wiring terminals are located in the peripheral wiring region A2. The multiple conductive wiring terminals can include signal input terminals, signal output terminals, and any other suitable terminals of the circuit configuration in the main substrate 11.

A flexible circuit board 12 can include a base substrate and a flexible driving circuit structure formed on the base substrate. The flexible driving circuit structure includes the multiple electrodes described above. Multiple connecting terminals of the flexible driving circuit structure can be corresponded to and connected with at least some of the conductive wiring terminals of the main substrate 11 to form an electrical connection between the flexible driving circuit structure and the main substrate 11.

The disclosed array substrate can be used as a display driving component. The main substrate 11 may refer to a main portion of an array substrate formed by fabricating corresponding structures on a substrate. The flexible circuit board 12 may refer to a portion disposed on the edge of the array substrate that is used for connecting an external circuit to the main substrate 11.

It should be understood that, in some embodiments, each flexible circuit board 12 may include an external circuit that is connected to the main substrate 11. For example, the external circuit connecting to the main substrate 11 can be a flexible driving circuit structure in the flexible circuit board 12.

In some embodiments, each flexible circuit board 12 may only include circuit configuration for connecting an external circuit and the main substrate 11. For example, an external circuit board can be bonded on the flexible circuit board 12. The external circuit board may include an external circuit electrically connected to the main substrate 11 through the flexible driving circuit structure of the flexible circuit board 12.

In some other embodiments, the at least one flexible circuit board 12 may include an external circuit connected to the main substrate 11, and the circuit configuration for connecting an external circuit and the main substrate 11 as well.

Further, the central display region A1 refers primarily to the active display region of the array substrate. The peripheral wiring region A2 refers primarily to the region outside the active display region for arranging the external connecting wires.

Moreover, the shapes, sizes, locations of the central display region A1 and the peripheral wiring region A2, and the number of the peripheral wiring region A2 shown in FIG. 2 are only exemplary. The shapes, sizes, locations of these components can be determined according to specific needs of various application scenarios.

Further, a base substrate of the flexible circuit board 12 can be a substrate mainly composed of cloth. Comparing to the conventional circuit boards that are mainly composed of a polyimide type material, the cloth formed flexible circuit board may be thinner and softer. Other materials that can form a thinner and softer base substrate in comparison to the conventional base substrate can also be used.

The fabricating process for forming the disclosed array substrate includes a process for forming a flexible driving circuit structure on a base substrate, and a process for bonding the flexible circuit board 12 to the edge of the main substrate 11. Therefore, the base substrate is required to meet the appropriate characteristics, such as insulation, heat resistance, toughness requirements, etc. In the specific application scenarios, one skilled in the art may select any suitable base substrate that adapts to the selected fabricating process.

Note that, the existing curved display apparatus with an external circuit component attached has a more severe light leakage problem compared to the curved display apparatus without an external circuit configuration attached. This is caused by a number of factors. On one side of the array substrate that is attached with an external circuit configuration, multiple metal wires and corresponding film layers are disposed in the peripheral wiring region. The external circuit configuration is normally bonded on the glass substrate by an adhesive using a hot pressing process. The external circuit configuration has a certain hardness, which can make the metal wires, the film layers, the adhesive, and the external circuit board generate certain stress on the glass substrate. Thus the side of the array substrate that is attached with the external circuit configuration suffers more stress compared to other sides of the array substrate. Therefore, the light generated in the glass substrate can have a retardation, thereby resulting in the light leakage problem.

Comparing to the conventional printed circuit (PCB) board and flexible printed circuit (FPC) board, the disclosed flexible circuit board can be more flexible. As such, when the display apparatus is bent, the stress applied to the main substrate can be reduced. Therefore, the light leakage at the edges of the display apparatus in the dark state can be reduced or eliminated. Accordingly, the disclosed subject matter can improve the uniformity of brightness level and the contrast of the display apparatus in the dark state, and can enhance the quality of the display of the display apparatus.

Specifically, in the light leakage scenario shown in FIG. 1, the curved ADS-LCD is in a dark state, and the four positions marked in circles are close to the upper and lower sides that is attached with chip on films (COF). The COF has a hardness such that causes stress on the edge of the curved display panel. The light in the glass substrate that has an uneven distribution of stress can have retardation. In various display modes of the ADS-LCD, the retardation can cause severe light leakage problems, such as shown in FIG. 1.

The disclosed subject matter can provide a transistor circuit in the central display region of the main substrate for the ADS-LCD in some embodiments. Thus, the light leakage problem can be alleviated by reducing the hardness of the circuit configuration that is bonded on the edge of the main substrate.

A material of the base substrate can be selected from any suitable material that can withstand the temperature during the process for forming the flexible driving circuit structure on the base substrate, and the temperature during the process for bonding the flexible circuit board to the edge of the main substrate. In some embodiments, a minimum standard for selecting the material for forming the base substrate can be withstanding a temperatures no lower than 200°C.

For example, a polytetrafluoroethylene (Teflon) high temperature cloth can be used for forming the base substrate of the flexible circuit board. The Teflon high temperature cloth not only satisfies the above temperature condition, but also has excellent strength, insulation, corrosion resistance and anti-static resistance characteristics.

As another example, the material for forming the base substrate can include polytetrafluoroethylene. In some embodiments, a base substrate that is formed by using the polytetrafluoroethylene as a main material can also have a high-temperature resistant property, which has a same or similar performance of the Teflon high temperature cloth.

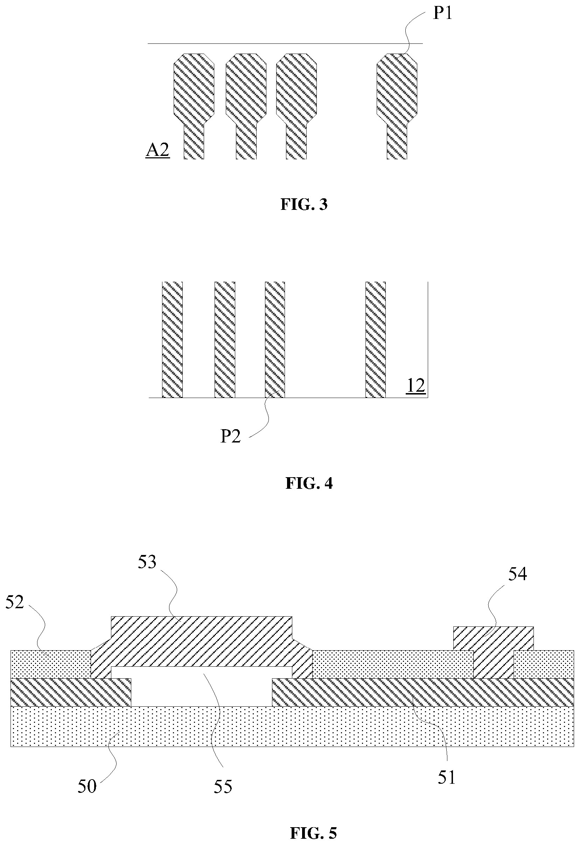

Referring to FIGS. 3 and 4, a schematic diagram of conductive wiring terminals in a peripheral wiring region on a main substrate is shown in FIG. 3, and a schematic diagram of connecting terminals of a flexible driving circuit structure on a flexible circuit board is shown in FIG. 4 in accordance with some embodiments of the disclosed subject matter.

As illustrated in FIG. 3, the conductive wiring terminals P1 in the peripheral wiring region A2 are conductive patterns formed near the edge of the main substrate 11. The conductive wiring terminals P1 can be mainly used for connecting to the external circuit for signal input or output.

As illustrated in FIG. 4, the connecting terminals P2 of the flexible driving circuit structure are conductive patterns formed on the edge of the flexible circuit board 12. The shapes and the arrangement of the connecting terminals P2 correspond to the he shapes and the arrangement of the conductive wiring terminals P1 on the main substrate 11. As such, the connecting terminals P2 can be correspondently connected with the conductive wiring terminals P1 to realize electrically connection between the main substrate 11 and the flexible driving circuit structure.

The surface of the flexible circuit board 12 shown in FIG. 3 may be attached to the surface of the main substrate 11 shown in Fig. 4, so that the four conductive wiring terminals P1 shown in FIG. 3 can be electrically connected to the corresponding connecting terminals P2 shown in FIG. 4 respectively.

In some embodiments, a hot pressing process can be used to attach at least one flexible circuit board 12 to the corresponding position(s) of the main substrate 11. Thus each of the conductive wiring terminals P1 can be connected to a corresponding connecting terminal P2 of the flexible driving circuit structure. As such, a desired circuit connection relationship can be formed.

Further, when the central display region A1 of the main substrate 11 includes a transistor circuit, the connecting terminals of the thin film transistor (including the signal input terminals and single output terminals, etc.) can be connected to at least some of the conductive wiring terminals P1 through conducting wires that extend to the peripheral wiring region A2. For example, the conducting wires connected with the conductive wiring terminals P1 shown in FIG. 3 can extend to the central display region A1, and be connected with the connecting terminals of the transistor circuit to form a desired circuit connection relationship on the main substrate 11.

Referring to FIG. 5, as a specific example of a flexible driving circuit structure, a schematic cross-sectional structural diagram of a flexible circuit board is shown in accordance with some embodiments of the disclosed subject matter.

As illustrated, the flexible driving circuit structure includes a patterned flexible conductive layer 51 formed on the base substrate 50, a patterned insulating layer 52 formed on the flexible conductive layer 51, and circuit chips and/or electronic components mounted on the flexible conductive layer 51 and the insulating layer 52.

Specifically, the patterned flexible conductive layer 51 may include patterns of inside connecting wires of the driver circuit, and the patterned insulating layer 52 may include solder resist patterns. Thus, the locations for the connecting terminals of the electronic components and the circuit chips can be reserved. For example, FIG. 5 shows two pins of the circuit chip 53 disposed in opening 55 of the solder resist patterns. The two pins of the circuit chip 53 are connected to the patterns of two connecting wires in the flexible conductive layer 51. One connecting wire on the right side can be connected to a terminal of electronic component 54 at another opening of the solder resist patterns.

Based on the arrangement of the flexible conductive layer, the insulating layer, and the circuit chips and/or electronic components, a circuit configuration having a desired circuit function can be obtained by an adaptive designing of the connecting wire patterns, the solder resist patterns, and the circuit chips and/or electronic components. The adaptive designing of the connecting wire patterns, the solder resist patterns, and the circuit chips and/or electronic components is similar to the existing process for forming a printed circuit board. Therefore, based on the arrangement of the flexible conductive layer, the insulating layer, and the circuit chips and/or electronic components, the disclosed flexible circuit board may have a thin structure with fewer layers comparing to the existing FPC and PCB, so that the final products can be thinner and lighter.

In some embodiments, a fabricating process for forming the flexible circuit board can include the steps described below.

First, a Teflon high temperature cloth can be used as a base substrate. A metal film can be formed on the flat surface of the base substrate by sputtering nickel alloy and copper. The metal film can then be thickened by plating copper to form a non-patterned flexible conductive layer.

Next, sprocket holes can be made on the formed structure by using a punching process. A photoresist film can then be coated on the surface of the metal layer. After an exposition process and a development process, a photoresist pattern film that is resistant to etching can be formed.

Thereafter, an etchant liquid such as CuCl₂, FeCl₃, etc. can be sprayed on to etch the metal film that is not covered by the photoresist pattern film. Thus a conductive layer including the connecting wire patterns can be formed.

Next, after peeling the photoresist pattern film, a tinning process can be performed on the patterned flexible conductive layer. An insulating resist film can be coated or printed as the solder resist patterns as described above.

Finally, based on the formed structure, circuit chips and/or electronic components can be installed in respective positions by using a reflow soldering process or a plug-in mounting process. After an appropriate external packaging process, a flexible circuit board that is adapted to the main substrate can be formed.

In some embodiments, the connecting terminals of the flexible driving circuit structure may be formed from some conductive structures in the flexible conductive layer that are at least partially exposed. For example, in the fabricating process of the flexible circuit board, the conductive patterns shown in FIG. 4 can be formed on the substrate as parts of the connecting wire patterns. And the solder resist patterns can be formed in the regions that are not occupied by the conductive patterns. Thus, the at least partially exposed conductive structures in the flexible conductive layer can form the connecting terminals of the flexible driving circuit structure. Thereby, no additional fabricating step is required to form the connecting terminals of the flexible driving circuit structure. The connecting terminals of the flexible driving circuit structure can be directly formed by designing the connecting wire patterns and the solder resist patterns.

Another aspect of the disclosed subject matter provides a fabricating method for forming the array substrate described above. The fabricating method can include the following steps.

At least one flexible circuit board can be formed, each flexible circuit board includes a flexible driving circuit structure formed on a base substrate, the flexible driving circuit structure has multiple connecting terminals.

A main substrate including multiple conductive wiring terminals can be formed.

The at least one flexible circuit board can be bonded on an edge of the main substrate to make multiple connecting terminals of the flexible driving circuit structure of each flexible circuit board being correspondently contacted with at least some of conductive wiring terminals of the main substrate.

In some embodiments, the main substrate includes a central display region and a peripheral wiring region. The multiple conductive wiring terminals are located in the peripheral wiring region.

As a specific example, the surface of the flexible circuit board 12 shown in FIG. 3 may be attached to the surface of the main substrate 11 shown in Fig. 4, so that the four conductive wiring terminals P1 shown in FIG. 3 can be electrically connected to the corresponding connecting terminals P2 shown in FIG. 4 respectively.

In some embodiments, a hot pressing process can be used to attach the at least one flexible circuit board 12 to the corresponding position(s) of the main substrate 11. As such, each of the conductive wiring terminals P1 can be connected to a corresponding connecting terminal P2 of the flexible driving circuit structure. Therefore, a desired circuit connection relationship can be formed.

It should be understood that, the disclosed fabricating method can form any array substrate described above. Based on different structures of different types of array substrates, the disclosed fabricating method can be performed accordantly.

The disclosed method can bond at least one flexible circuit board on an edge of a main substrate, and form a flexible driving circuit structure on a base substrate of each flexible circuit board. The flexible driving circuit structure can substitute the function of the existing binding peripheral circuit board.

The disclosed flexible circuit board can have a reduced hardness. Thus when the display apparatus is bent, the stress applied to the main substrate can be reduced. Therefore, the light leakage at the edges of the display apparatus in the dark state can be reduced or eliminated. Accordingly, the disclosed subject matter can improve the uniformity of brightness and the contrast of the display apparatus in the dark state, and can enhance the quality of the display of the display apparatus.

Another aspect of the disclosed subject matter provides a related display apparatus that includes any one array substrate described above. Specific types of the display apparatus can include a monitor, an electronic paper, a tablet computer, a television, a smart phone, a smart tag, a smart card, a smart glasses, a smart watch, a digital photo frame, a navigation system, or any other products or components having a display function.

For the display apparatus including any one array substrate described above, the disclosed subject matter can improve the uniformity of brightness and the contrast of the display apparatus in the dark state, and can enhance the display effect of the display apparatus.

The provision of the examples described herein (as well as clauses phrased as "such as," "e.g.," "including," and the like) should not be interpreted as limiting the claimed subject matter to the specific examples; rather, the examples are intended to illustrate only some of many possible aspects.

Accordingly, a flexible circuit board, an array substrate, a fabricating method thereof, and a related display apparatus are provided.

The disclosed flexible circuit board can comprise a base substrate made of a soft cloth material, and a flexible driving circuit structure formed on the base substrate. The base substrate can withstand a temperature during a process for forming the flexible driving circuit structure on the base substrate, and a temperature during a process for bonding the flexible circuit board to a main substrate. The soft cloth material can include polytetrafluoroethylene.

In some embodiments, the flexible driving circuit structure comprises a patterned flexible conductive layer including a plurality of conducting wires, a patterned flexible insulating layer formed on the patterned flexible conductive layer, and at least one circuit chip plugged in the patterned flexible insulating layer and contacted with the patterned flexible conductive layer. The patterned flexible conductive layer can be made of a conductive ink being printed on the base substrate.

The disclosed array substrate can comprise a main substrate including a central display region and a peripheral wiring region. A plurality of conducting wire terminals are disposed in the peripheral wiring region. At least one disclosed flexible circuit board can be bonded on the peripheral wiring region of the main substrate. The flexible driving circuit structure of each flexible circuit board further includes a plurality of connecting terminals that are correspondently electrically connected with at least a part of the plurality of conducting wire terminals of the main substrate.

In some embodiments, the base substrate is a polytetrafluoroethylene high temperature cloth.

In some embodiments, the array substrate further comprises a thin film transistor in the central display region of the main substrate, a plurality of connecting terminals of the thin film transistor are connected to at least a part of the plurality of conductive wiring terminals through a part of the plurality of conducting wires that extend to the peripheral wiring region.

The disclosed method for fabricating a flexible circuit board can comprise using a soft cloth material to form a base substrate, and forming a flexible driving circuit structure on the base substrate.

The disclosed method for fabricating an array substrate can comprises:
forming a main substrate including a central display region and a peripheral wiring region, a plurality of conducting wire terminals are disposed in the peripheral wiring region; forming at least one flexible circuit board using the disclosed method;
and bonding the at least one flexible circuit board on the peripheral wiring region.

In some embodiments, the at least one flexible circuit board is bounded on the peripheral wiring region of the main substrate by a hot pressing process, the base substrate is formed of a polytetrafluoroethylene high temperature cloth.

In some embodiments, forming each flexible circuit board comprises:
forming a metal film on a flat surface of the base substrate by sputtering nickel alloy and copper; thickening the metal film by plating copper to form a non-patterned flexible conductive layer; using a punching process to form at least one sprocket hole in the non-patterned flexible conductive layer, forming a photoresist pattern film on a surface of the non-patterned flexible conductive layer; and spraying an etchant liquid to etch the non-patterned flexible conductive layer that is not covered by the photoresist pattern film to form a patterned flexible conductive layer including a plurality of connecting wires.

In some embodiments, forming each flexible circuit board comprises printing a conductive ink on the base substrate to form a patterned flexible conductive layer.

In some embodiments, forming each flexible circuit board further comprises:
after releasing the photoresist pattern film, performing a tinning process on the patterned flexible conductive layer; printing an insulating resist film to form a patterned insulating layer on the patterned flexible conductive layer; plugging at least one circuit chip into the patterned insulating layer by using a reflow process and
a cartridge process to make the at least one circuit chip contact with the patterned flexible conductive layer; and performing an external packaging process

Although the disclosed subject matter has been described and illustrated in the foregoing illustrative embodiments, it is understood that the present disclosure has been made only by way of example, and that numerous changes in the details of embodiment of the invention can be made within the scope of the claims.

## Claims

1. An array substrate, comprising:
a main substrate (11) comprising a central display region (A1) and a peripheral wiring region (A2), a plurality of conducting wire terminals (P1) are disposed in the peripheral wiring region (A2); and
at least one flexible circuit board (12) bonded on the peripheral wiring region (A2) of the main substrate (11), **characterized in that** the at least one flexible circuit board (12) comprises a base substrate (50) made of a soft cloth including polytetrafluoroethylene; and
a flexible driving circuit structure formed on the base substrate (50).

2. The array substrate of claim 1, wherein:
the base substrate (50) withstands a temperature during a process for forming the flexible driving circuit structure on the base substrate (50), and a temperature during a process for bonding the flexible circuit board (12) to the main substrate (11);
the base substrate (50) is a polytetrafluoroethylene high temperature cloth, and
the withstood temperature of the base substrate (50) is no lower than 200°C.

3. The array substrate of claim 1, wherein the flexible driving circuit structure comprises:
a patterned flexible conductive layer (51) including a plurality of conducting wires;
a patterned flexible insulating layer (52) formed on the patterned flexible conductive layer (51); and
at least one circuit chip (53) plugged in the patterned flexible insulating layer (52) and contacted with the patterned flexible conductive layer (51);
preferably, the patterned flexible conductive layer (51) is made of a conductive ink being printed on the base substrate (50).

4. The array substrate of claim 1, wherein:
the flexible driving circuit structure of each flexible circuit board (12) further includes a plurality of connecting terminals (P2) that are correspondently electrically connected with at least a part of the plurality of conducting wire terminals (P1) of the main substrate (11).

5. The array substrate of claim 1, wherein:
the plurality of connecting terminals (P2) of the flexible driving circuit structure is formed from the plurality of conducting wires in the patterned flexible conductive layer (51).

6. The array substrate of claim 1, further comprising:
a thin film transistor in the central display region (A1) of the main substrate (11);
wherein a plurality of connecting terminals (P2) of the thin film transistor are connected to at least a part of the plurality of conductive wiring terminals (P1) through a part of the plurality of conducting wires that extend to the peripheral wiring region (A2).

7. A method for fabricating an array substrate, comprising:
forming a main substrate (11) comprising a central display region (A1) and a peripheral wiring region (A2), a plurality of conducting wire terminals (P1) are disposed in the peripheral wiring region (A2);
forming at least one flexible circuit board (12); and bonding the at least one flexible circuit board (12) on the peripheral wiring region (A2);
wherein, forming at least one flexible circuit board (12) comprising:
providing a base substrate (50) which is a soft cloth including polytetrafluoroethylene; and
forming a flexible driving circuit structure on the base substrate (50).

8. The method of claim 7, wherein:
the at least one flexible circuit board (12) is bounded on the peripheral wiring region (A2) of the main substrate (11) by a hot pressing process.

9. The method of claim 7, wherein:
the base substrate (50) is formed of a polytetrafluoroethylene high temperature cloth.

10. The method of claim 7, wherein forming each flexible circuit board (12) comprising:
forming a metal film on a flat surface of the base substrate (50) by sputtering nickel alloy and copper;
thickening the metal film by plating copper to form a non-patterned flexible conductive layer (51); and
using a punching process to form at least one sprocket hole (55) in the non-patterned flexible conductive layer (51);
preferably, wherein forming each flexible circuit board (12) further comprising:
forming a photoresist pattern film on a surface of the non-patterned flexible conductive layer (51); and
spraying an etchant liquid to etch the non-patterned flexible conductive layer (51) that is not covered by the photoresist pattern film to form a patterned flexible conductive layer (51) including a plurality of connecting wires.

11. The method of claim 7, wherein forming each flexible circuit board (12) comprising:
printing a conductive ink on the base substrate (50) to form a patterned flexible conductive layer (51).

12. The method of claim 10 or 11, wherein forming each flexible circuit board (12) further comprising:
performing a tinning process on the patterned flexible conductive layer (51); and
printing an insulating resist film to form a patterned insulating layer (52) on the patterned flexible conductive layer (51);
preferably, wherein forming each flexible circuit board (12) further comprising:
plugging at least one circuit chip (53) into the patterned insulating layer (52) by using a reflow process and a cartridge process to make the at least one circuit chip (53) contact with the patterned flexible conductive layer (51); and
performing an external packaging process.

13. A display apparatus, comprising the array substrate according to any one of claims 1-6.

## Patentansprüche

1. Array-Substrat, aufweisend:
ein Hauptsubstrat (11) mit einem zentralen Anzeigebereich (A1) und einem peripheren Verdrahtungsbereich (A2), wobei mehrere leitende Drahtanschlüsse (P1) in dem peripheren Verdrahtungsbereich (A2) angeordnet sind; und
mindestens eine flexible Leiterplatte (12), die an den peripheren Verdrahtungsbereich (A2) des Hauptsubstrats (11) gebonded ist, **dadurch gekennzeichnet, dass** die mindestens eine flexible Leiterplatte (12) ein Basissubstrat (50) aufweist, das aus einem weichen Gewebe hergestellt ist, das Polytetrafluorethylen enthält; und
eine flexible Treiberschaltungsstruktur, die auf dem Basissubstrat (50) gebildet ist.

2. Array-Substrat nach Anspruch 1, wobei:
das Basissubstrat (50) einer Temperatur während eines Prozesses zum Bilden der flexiblen Treiberschaltungsstruktur auf dem Basissubstrat (50) und einer Temperatur während eines Prozesses zum Bonden der flexiblen Leiterplatte (12) an das Hauptsubstrat (11) standhält;
das Basissubstrat (50) ein Polytetrafluorethylen-Hochtemperaturgewebe ist, und
die Temperatur des Basissubstrats (50), der standgehalten wird, nicht unter 200 °C liegt.

3. Array-Substrat nach Anspruch 1, wobei die flexible Treiberschaltungsstruktur aufweist:
eine strukturierte flexible leitfähige Schicht (51), die mehrere leitende Drähte aufweist;
eine strukturierte flexible Isolierschicht (52), die auf der strukturierten flexiblen leitfähigen Schicht (51) gebildet ist; und
mindestens einen Schaltungschip (53), der in die strukturierte flexible Isolierschicht (52) eingesteckt und mit der strukturierten flexiblen leitfähigen Schicht (51) kontaktiert wird;
vorzugsweise ist die strukturierte flexible leitfähige Schicht (51) aus einer leitfähigen Tinte hergestellt, die auf das Basissubstrat (50) gedruckt wird.

4. Array-Substrat nach Anspruch 1, wobei:
die flexible Treiberschaltungsstruktur jeder flexiblen Leiterplatte (12) ferner mehrere Verbindungsanschlüsse (P2) aufweist, die entsprechend elektrisch mit mindestens einem Teil der mehreren leitenden Drahtanschlüsse (P1) des Hauptsubstrats (11) verbunden sind.

5. Array-Substrat nach Anspruch 1, wobei:
die mehreren Verbindungsanschlüsse (P2) der flexiblen Treiberschaltungsstruktur aus den mehreren leitenden Drähten in der strukturierten flexiblen leitfähigen Schicht (51) gebildet ist.

6. Array-Substrat nach Anspruch 1, ferner aufweisend:
einen Dünnfilmtransistor in dem zentralen Anzeigebereich (A1) des Hauptsubstrats (11);
wobei mehrere Verbindungsanschlüssen (P2) des Dünnfilmtransistors mit mindestens einem Teil der mehreren leitfähigen Verdrahtungsanschlüsse (P1) durch einen Teil der mehreren leitenden Drähte verbunden sind, die sich zu dem peripheren Verdrahtungsbereich (A2) erstrecken.

7. Verfahren zur Herstellung eines Array-Substrats, aufweisend:
Bilden eines Hauptsubstrats (11) mit einem zentralen Anzeigebereich (A1) und einem peripheren Verdrahtungsbereich (A2), wobei mehrere leitende Drahtanschlüsse (P1) in dem peripheren Verdrahtungsbereich (A2) angeordnet werden;
Bilden mindestens einer flexiblen Leiterplatte (12); und Bonden der mindestens einen flexiblen Leiterplatte (12) an den peripheren Verdrahtungsbereich (A2);
wobei das Bilden mindestens einer flexiblen Leiterplatte (12) umfasst:
Vorsehen eines Basissubstrats (50), das ein weiches Gewebe ist, das Polytetrafluorethylen enthält; und
Bilden einer flexiblen Treiberschaltungsstruktur auf dem Basissubstrat (50).

8. Verfahren nach Anspruch 7, wobei:
die mindestens eine flexible Leiterplatte (12) durch einen Heißpressprozess an den peripheren Verdrahtungsbereich (A2) des Hauptsubstrats (11) gebondet wird.

9. Verfahren nach Anspruch 7, wobei:
das Basissubstrat (50) aus einem Polytetrafluorethylen-Hochtemperaturgewebe gebildet wird.

10. Verfahren nach Anspruch 7, wobei das Bilden jeder flexiblen Leiterplatte (12) umfasst:
Bilden eines Metallfilms auf einer flachen Oberfläche des Basissubstrats (50) durch Sputtern von Nickellegierung und Kupfer;
Verdicken des Metallfilms durch Plattieren von Kupfer, um eine nicht strukturierte flexible leitfähige Schicht (51) zu bilden; und
Verwenden eines Stanzprozesses, um mindestens ein Führungsloch (55) in der nicht strukturierten flexiblen leitfähigen Schicht (51) zu bilden;
wobei das Bilden jeder flexiblen Leiterplatte (12) vorzugsweise ferner umfasst:
Bilden eines Photoresistmusterfilms auf einer Oberfläche der nicht strukturierten flexiblen leitfähigen Schicht (51); und
Sprühen einer Ätzflüssigkeit zum Ätzen der nicht strukturierten flexiblen leitfähigen Schicht (51), die nicht von dem Photoresistmusterfilm bedeckt ist, um eine strukturierte flexible leitfähige Schicht (51) zu bilden, die mehrere Verbindungsdrähte aufweist.

11. Verfahren nach Anspruch 7, wobei das Bilden jeder flexiblen Leiterplatte (12) umfasst:
Drucken einer leitfähigen Tinte auf das Basissubstrat (50), um eine strukturierte flexible leitfähige Schicht (51) zu bilden.

12. Verfahren nach Anspruch 10 oder 11, wobei das Bilden jeder flexiblen Leiterplatte (12) ferner aufweist:
Durchführen eines Verzinnungsprozesses auf der strukturierten flexiblen leitfähigen Schicht (51); und
Drucken eines isolierenden Resistfilms zur Bildung einer strukturierten Isolierschicht (52) auf der strukturierten flexiblen leitfähigen Schicht (51);
wobei das Bilden jeder flexiblen Leiterplatte (12) vorzugsweise ferner umfasst:
Einstecken mindestens eines Schaltungschips (53) in die strukturierte Isolierschicht (52) unter Verwendung eines Reflow-Prozesses und eines Patronenprozesses, um den mindestens einen Schaltungschip (53) mit der strukturierten flexiblen leitfähigen Schicht (51) zu kontaktieren; und
Durchführen eines externen Verpackungsprozesses.

13. Anzeigevorrichtung, das Array-Substrat nach einem der Ansprüche 1-6 aufweisend.

## Revendications

1. Substrat de réseau, comprenant :
un substrat principal (11) comprenant une région d'affichage centrale (A1) et une région de câblage périphérique (A2), une pluralité de bornes de fils conducteurs (P1) qui sont disposées dans la région de câblage périphérique (A2) ; et
au moins une carte de circuit imprimé flexible (12) collée sur la région de câblage périphérique (A2) du substrat principal (11), **caractérisée en ce que** ladite au moins une carte de circuit imprimé flexible (12) comprend un substrat de base (50) constitué d'un tissu souple comprenant du polytétrafluoroéthylène ; et
une structure de circuit d'attaque flexible formée sur le substrat de base (50).

2. Substrat de réseau selon la revendication 1, dans lequel :
le substrat de base (50) résiste à une température pendant un processus de formation de la structure de circuit d'attaque flexible sur le substrat de base (50), et à une température pendant un processus de collage de la carte de circuit imprimé flexible (12) au substrat principal (11) ;
le substrat de base (50) est un polytétrafluoroéthylène à haute température, et la température de résistance du substrat de base (50) n'est pas inférieure à 200 ° C.

3. Substrat de réseau selon la revendication 1, dans lequel la structure de circuit d'attaque flexible comprend :
une couche conductrice flexible à motif (51) comprenant une pluralité de fils conducteurs ;
une couche isolante flexible à motif (52) formée sur la couche conductrice flexible à motif (51) ; et
au moins une puce de circuit (53) enfichée dans la couche isolante flexible à motif (52) et en contact avec la couche conductrice flexible à motif (51) ;
de préférence, la couche conductrice flexible à motif (51) est constituée d'une encre conductrice imprimée sur le substrat de base (50).

4. Substrat de réseau selon la revendication 1, dans lequel :
la structure de circuit d'attaque flexible de chaque carte de circuit imprimé flexible (12) comprend en outre une pluralité de bornes de connexion (P2) qui sont connectées électriquement en correspondance avec au moins une partie de la pluralité de bornes de fils conducteurs (P1) du substrat principal (11).

5. Substrat de réseau selon la revendication 1, dans lequel :
la pluralité de bornes de connexion (P2) de la structure de circuit d'attaque flexible est formée à partir de la pluralité de fils conducteurs dans la couche conductrice flexible à motif (51).

6. Substrat de réseau selon la revendication 1, comprenant en outre :
un transistor à couche mince dans la région d'affichage centrale (A1) du substrat principal (11) ;
dans lequel une pluralité de bornes de connexion (P2) du transistor à couches minces sont connectées à au moins une partie de la pluralité de bornes de fils conducteurs (P1) à travers une partie de la pluralité de fils conducteurs qui s'étendent jusqu'à la région de câblage périphérique (A2).

7. Procédé de fabrication d'un substrat de réseau, comprenant l'étape consistant à :
former un substrat principal (11) comprenant une région d'affichage centrale (A1) et une région de câblage périphérique (A2), une pluralité de bornes de fils conducteurs (P1) sont disposées dans la région de câblage périphérique (A2) ;
former au moins une carte de circuit imprimé flexible (12) ; et coller ladite au moins une carte de circuit imprimé flexible (12) sur la région de câblage périphérique (A2) ;
dans lequel, former au moins une carte de circuit imprimé flexible (12) comprend les étapes consistant à :
fournir un substrat de base qui est un tissu souple comprenant du polytétrafluoroéthylène ; et
former une structure de circuit d'attaque flexible sur le substrat de base (50).

8. Procédé selon la revendication 7, dans lequel :
ladite au moins une carte de circuit imprimé flexible (12) est délimitée sur la région de câblage périphérique (A2) du substrat principal (11) par un processus de pressage à chaud.

9. Procédé selon la revendication 7, dans lequel :
le substrat de base (50) est formé d'un tissu à haute température en polytétrafluoroéthylène.

10. Procédé selon la revendication 7, dans lequel la formation de chaque carte de circuit imprimé flexible (12) comprend les étapes consistant à :
former un film métallique sur une surface plane du substrat de base (50) par pulvérisation d'un alliage de nickel et de cuivre ;
épaissir le film métallique en plaçant du cuivre pour former une couche conductrice flexible sans motif (51) ; et
utiliser un processus de poinçonnage pour former au moins un trou de pignon (55) dans la couche conductrice flexible sans motif (51) ;
de préférence, dans lequel la formation de chaque carte de circuit imprimé flexible (12) comprend en outre les étapes consistant à :
former un film à motif en résine photosensible sur une surface de la couche conductrice flexible sans motif (51) ; et
pulvériser un liquide de gravure pour graver la couche conductrice flexible sans motif (51) qui n'est pas recouverte par le film à motif photorésistant pour former une couche conductrice flexible à motif (51) comprenant une pluralité de fils de connexion.

11. Procédé selon la revendication 7, dans lequel la formation de chaque carte de circuit imprimé flexible (12) comprend l'étape consistant à :
imprimer une encre conductrice sur le substrat de base (50) pour former une couche conductrice flexible à motif (51).

12. Procédé selon la revendication 10 ou 11, dans lequel la formation de chaque carte de circuit imprimé flexible (12) comprend en outre les étapes consistant à :
effectuer un processus d'étamage sur la couche conductrice flexible à motif (51) ; et
imprimer un film de réserve isolant pour former une couche isolante à motif (52) sur la couche conductrice flexible à motif (51) ;
de préférence, dans lequel la formation de chaque carte de circuit imprimé flexible (12) comprend en outre les étapes consistant à :
brancher au moins une puce de circuit (53) dans la couche isolante à motif (52) en utilisant un processus de refusion et un processus de cartouche pour mettre ladite au moins une puce de circuit (53) en contact avec la couche conductrice flexible à motif (51) ; et
effectuer un processus d'emballage externe.

13. Appareil d'affichage, comprenant le substrat de réseau selon l'une quelconque des revendications 1 à 6.
